Europäisches Patentamt

(19) European Patent Office

Office européen des brevets

(11) **EP 0 310 453 B2**

(12) **NEW EUROPEAN PATENT SPECIFICATION**

(45) Date of publication and mention
of the opposition decision:
**02.01.1997 Bulletin 1997/01**

(45) Mention of the grant of the patent:
**12.05.1993 Bulletin 1993/19**

(21) Application number: **88309193.6**

(22) Date of filing: **03.10.1988**

(51) Int. Cl.⁶: $C04B\ 35/00$, $H01L\ 39/24$, $C04B\ 41/88$

(54) **Method of producing an oxide superconductor without a sheath and an oxide superconductor produced by the method**

Verfahren zur Darstellung eines oxidischen Supraleiters ohne Ummantelung und ein nach diesem Verfahren hergestellter oxidischer Supraleiter

Méthode d'obtention d'un oxyde supraconducteur sans enveloppe et oxyde supraconducteur obtenu par cette méthode

(84) Designated Contracting States:
**CH DE FR GB LI NL**

(30) Priority: 28.10.1987 JP 272302/87
28.10.1987 JP 272303/87
08.12.1987 JP 309998/87
06.11.1987 JP 280450/87
30.11.1987 JP 302178/87
11.01.1988 JP 3329/88
28.12.1987 JP 332407/87
28.12.1987 JP 332408/87
27.01.1988 JP 16305/88
08.03.1988 JP 54042/88
28.03.1988 JP 73929/88
28.03.1988 JP 73928/88
08.12.1987 JP 309996/87
06.11.1987 JP 280452/87
25.11.1987 JP 296704/87
02.10.1987 JP 249525/87
02.10.1987 JP 249526/87
28.10.1987 JP 272304/87
06.11.1987 JP 280453/87
06.11.1987 JP 280451/87

(43) Date of publication of application:
**05.04.1989 Bulletin 1989/14**

(73) Proprietor: **FUJIKURA LTD.**
**Kohtoh-ku Tokyo (JP)**

(72) Inventors:
• **Ikeno, Yoshimitsu**
**Tokyo (JP)**
• **Kohno, Osamu**
**Tokyo (JP)**
• **Goto, Kenji**
**Tokyo (JP)**
• **Kume, Atsushi**
**Tokyo (JP)**
• **Aoki, Shin'Ya**
**Tokyo (JP)**
• **Sadakata, Nobuyuki**
**Tokyo (JP)**
• **Sugimoto, Masaru**
**Tokyo (JP)**
• **Usui, Toshio**
**Tokyo (JP)**
• **Nakagawa, Mikio**
**Tokyo (JP)**
• **Yamaguchi, Taichi**
**Tokyo (JP)**

(74) Representative: **Calderbank, Thomas Roger et al**
**MEWBURN ELLIS**
**York House**
**23 Kingsway**
**London WC2B 6HP (GB)**

(56) References cited:
EP-A- 250 322          EP-A- 0 282 286
EP-A- 0 283 312

• **APPLIED PHYSICS LETTERS, vol. 51, no. 3, 20th July 1987, pages 203-204, American Institute of Physics; S. JIN et al.: "High Tc superconductors-composite wire fabrication"**
• **ADVANCED CERAMIC MATERIALS, vol. 2, no. 3B, special issue, July 1987, pages 388-400; R.W. McCALLUM et al.: "Problems in the production of YBa2Cu3Ox superconducting wire"**

- **Japanese Journal of applied Physics, 26, no. 5, May (1987) L865-L866 Yamada et al.**

Remarks:

Additinal priorities 21-31 (021087) 249527/87, 249528/87, (161087) 261173/87, (161187) 288679/87, (081287) 309997/87, (281287) 332405/87, 332404/87, 332409/87, 332411/87, 332412/87, (290188) 18589/88.

## Description

The present invention relates to a method of producing an oxide superconductor.

Intense efforts in research and development are directed toward superconductive oxides for practical use, for example, magnet coils of the nuclear magnetic resonance imaging apparatus, magnet coils of the particle accelerator, the power transmission line and a like use. The present invention seeks to provide a method of producing a superconductor which exhibits excellent superconductivity, particularly high critical current density as compared to the superconductor produced by known methods.

Oxide superconductors have been proposed in the following specifications;

EP-A-0283312 entitled "Method of producing a superconducting wire and a superconducting wire produced according to the same";
EP-A-0283313 entitled "Method of producing oxide superconducting wire and oxide superconducting wire produced by this method;"
EP-A-0297707 entitled "Superconductive electric wire and method for making it";
EP-A-0286372 entitled "Oxide superconductor and manufacturing method thereof"; and
EP-A-0299788 entitled "Method of producing a superconducting wire including an oxide superconductor".

Recently, various superconductive oxides with high critical temperatures (Tc) have been discovered. For producing superconducting wires including such superconductive oxides, for example, Y-Ba-Cu oxide, there has been proposed that a powder mixture which includes $Y_2O_3$ powder, BaO powder and CuO powder is charged into a metallic pipe, which is then diameter reduced to form a composite wire, which is in turn heat treated for a solid-state reaction so that the superconductive oxide is produced in the core. According to such a method, it is however difficult to improve critical current density of the superconducting wire in spite of various efforts.

With intensive study, we have found that this difficulty is caused by a fact that during the heating treatment, the oxide core is damaged by tensile stresses due to the difference in thermal expansion between the metallic sheath and the oxide core, so that the superconductivity of the superconducting wire is degraded. Our experiments revealed that the sheathed superconducting wire above described exhibited 1/2 to 1/5 in critical current density of a bulk material of the same superconductive oxide.

Japanese J. Applied Physics, vol. 26, no. 5, May 1987, L865-866, Yamada et al. discloses a method of forming a wire of Y-Ba-Cu oxide superconductor by a powder metallurgy technique. The oxide superconductor is packed into a copper tube, after cold working the tube is removed chemically.

European patent application EP-A-0250 322 discloses a method of producing an elongated sintered article. Ceramic powder is placed in a metal pipe, after wire drawing the pipe is removed by either chemical or mechanical means.

The present invention provides a method of producing a superconducting wire including a superconductive oxide represented by the formula

$$A_xB_yC_zD_{7-\delta}$$

provided that the A is at least one selected from the group consisting of Y, La, Eu, Ho and Er, the B is at least one selected from the group consisting of Sr, Ca and Ba, the C consists essentially of Cu, or Cu plus at least one element among Ag, Au and Nb, the D consists essentially of O, or O plus at least one element among S, Se, Te, Po, F, Cl, Br, I and At, $0.1 \leqq x \leqq 2.0$, $1 \leqq y \leqq 3$, $1 \leqq z \leqq 3$, $0 \leqq \delta \leqq 5$, or by the formula

$$A_xB_yCa_zCu_iO_j$$

provided that the A consists essentially of Bl or Tl, the B consists essentially of Sr or Ba, $1 \leqq x \leqq 3$, $1 \leqq y \leqq 3$, $0 \leqq z \leqq 3$ and $0 \leqq i \leqq 4$, comprising the steps of:

(a) charging into a metallic pipe for forming a preform at least one filling material selected from the group consisting of: a starting material powder of the superconductive oxide; a powder of the superconductive oxide;
b) reducing in cross-sectional area the preform for forming a composite including a core, made of the at least one filling material, and a metallic sheath covering the core;
(c) removing the metallic sheath of the composite, cross-sectional area reduced in the step (b) for exposing the core; and
(d) heat treating the exposed core for producing the superconductive oxide; wherein the metallic sheath is removed by high frequency induction heating.

Accordingly, the present invention permits a superconductor to be produced which exhibits excellent superconductivity, particularly high critical current density as compared to the superconductor produced by the known methods.

Embodiments of the present invention will now be described in detail, by way of example, with reference to the accompanying drawings, in which:

FIG 1 is an enlarged cross-sectional view of a preform according to the present invention:
FIG. 2 is an enlarged cross-sectional view of a modified form of the preform in FIG. 1;
FIG. 3 is an enlarged cross-sectional view of a composite wire produced by diameter reducing the preform in FIG. 1;

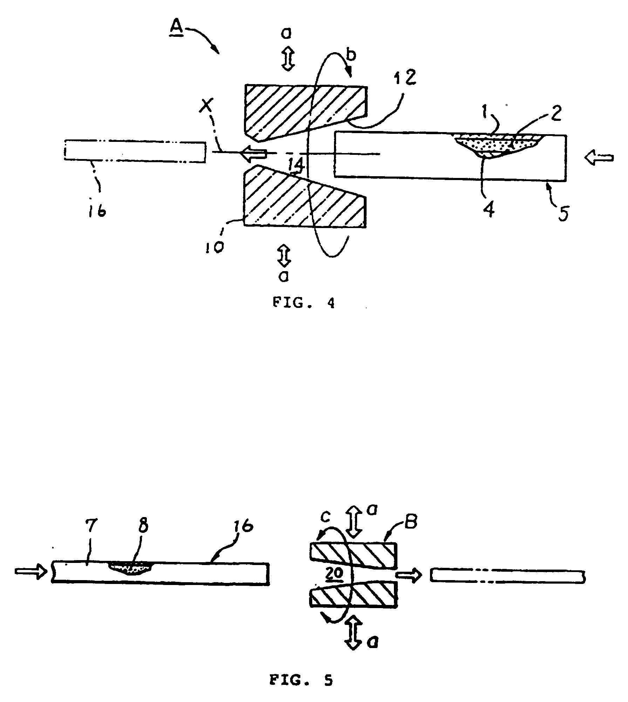

FIG. 4 is a diagrammatic illustration of a rotary swaging machine, in which a composite wire of the preform in FIG.2 is introduced;

FIG. 5 is a diagrammatic illustration of another swaging machine for further swaging the composite wire processed in the swaging machine in FIG. 4;

FIG. 6 is an enlarged cross-sectional view of the core obtained by removing the sheath of the composite in FIG. 3;

FIG. 7 is a perspective view of an induction heating appliance usable in the present invention;

FIG. 8 is a diagrammatic illustration of a modified form of the induction heating appliance in FIG. 7;

FIG. 9 is an enlarged receptacle for recovering a molten metal in the heating appliance in FIG. 8;

FIG. 10 is an enlarged cross-sectional view of a superconductor coated according to the present invention;

FIG. 11 is an illustration of a hot dipping process used in one preferred mode of the present invention;

FIG. 12 is an enlarged cross-sectional view of a heat treated core coated with a buffer layer according to the present invention;

FIG. 13 is a cross-sectional view of the coated core in FIG. 12 sheathed with a metallic sheath;

FIG. 14 is a perspective view of an apparatus for producing a multifilamentary superconductor according to the present invention;

FIG. 15 is an enlarged cross-sectional view of the multifilamentary superconductor produced by the apparatus in FIG. 14; and

FIG. 16 is an enlarged cross-sectional view of a modified multifilamentary superconductor in FIG. 15.

## The superconductive oxide

In the present invention, superconductive oxide is represented by the formula

$$A_xB_yC_zD_{7-\delta}$$

provided that the A is at least one selected from the group consisting of Y, La, Ce, Eu, Gd, Dy, Ho and Er, the B is at least one selected from the group consisting of Sr, Ca and Ba, the C consists essentially of Cu or Cu plus at least one element among Ag, Au and Nb, the D consists essentially of O or O plus at least one element among S, Se, Te, Po, F, Cl, Br, I and At,
$0.1 \leqq x \leqq 2.0$, $1 \leqq y \leqq 3$, $1 \leqq z \leqq 3$, $0 \leqq \delta \leqq 5$, or by the formula

$$A_xB_yCa_zCu_iO_j$$

provided that the A consists essentiall of Bi or Tl, the B consists essentially of Sr or Ba, $1 \leqq x \leqq 3$, $1 \leqq y \leqq 3$, $0 \leqq z \leqq 3$ and $0 \leqq i \leqq 4$. A typical example of the $A_xB_yC_zD$ is $Y_1Ba_2Cu_3O_{7-\delta}$, and preferably x=1, y=2, z=3 $0 \leqq$ $\delta \leqq 1$, but typically is about 0, and the oxide superconductor is orthorhombic. Typically examples of the $A_xB_yCa_zCu_iO_j$ are $Bi_2Sr_2Ca_2Cu_3O_j$, $Bi_2Sr_2CaCu_2O_j$, $TlCa_2Ba_3Cu_4O_j$, $Tl_2Ca_2Ba_2Cu_3O_j$, $Tl_2Ca_2Ba_1Cu_3O_j$.

The filling material according to the present invention may include; a starting material powder, including the elements which constitute the oxide superconductor; a green compact of such a starting material powder; calcined green compact of the starting material powder; and a superconducting material obtained by sintering the green compact or by pulverizing the sintered compact. The filler may be in the form of powder, granule, compacted body of such a material or a mixture thereof.

The starting material powder may contain; for example, a mixture of a powder of the A element or elements, a powder or a carbonate of the B element or elements, and a powder of the C element or elements; a pulverized, calcined powder of such a mixture; or a like powder. The powder of IIIa group elements, Y, La, Eu, Dy, Ho and Er, may be in the form of a powder of a compound such as a carbonate, oxide, chloride, sulfide, oxalate and fluoride thereof and in the form of an alloy powder thereof. As the IIIa group powder, an oxide powder thereof with a particle size about 5 $\mu$m or smaller is preferably used. The powder including Bi may be a powder of an oxalate thereof and the powder containing Tl may be a powder of $Tl_2O_3$. The powder of IIa group elements, may be in the form of a powder of a compound such as a carbonate, oxide, chloride, sulfide, oxalate and fluoride thereof and in the form of an alloy powder thereof. As the IIa group powder, a carbonate powder thereof with a particle size about 3 $\mu$m or smaller is preferably used. The powder containing copper may be a powder of a copper oxide including CuO, $Cu_2O$, $Cu_2O_3$ and $Cu_4O_3$. A CuO powder of a particle size of about 3 $\mu$m or smaller is preferably used. The mixing ratio of these compounds depends on a desired superconductor. For $Y_1Ba_2Cu_3O_{7-\delta}$, $Y_2O_3$, $BaCO_3$ and CuO powders are preferably mixed so that Y : Ba : Cu = 1 : 2 : 3 at mole ratio. The starting material powder may have a particle size of 4 $\mu$m or smaller, preferably 1 to 2 $\mu$m. Within such a preferable range, excellent heat diffusion of elements of the superconductive oxide may occur.

The starting material powder for the A-B-Cu-O superconductor may be prepared by the following so-called sol-gel method. An aqueous solution of the A element, the B element and Cu is prepared by weighing a soluble salt, such as a nitrate and acetate, of these elements at predetermined ratio, and then by dissolving them into a predetermined amount of water. The total concentration of the salts of these elements in the aqueous solution is preferably 0.5 to 10 wt.% but it depends on the kind of the soluble salt. Such an aqueous solution may be prepared by dissolving an oxide or carbonate of each element by an aqueous solution of nitric acid or acetic acid. Then, an acid, preferably carboxylic acid such as citric acid, succinic acid and tartaric acid, is added to the aqueous solution of the elements. 5 to 20 wt.% of citric acid is used per 100 wt.% of the aqueous solution. The amount of the other acids depends on the kind thereof. The acid added aqueous solution is then neutralized by adding a basic material, such as ammonia, ammonium carbonate, guanidine and ammonium acetate, to obtain a neutralized aqueous solution of about pH 7. As the basic material, an aqueous ammonia is preferably used. Then, the neutralized aqueous solution is heated to evaporate water and further to decompose or pyrolize the acid material and basic material, so that a solid sponge material (mixture) of oxides or carbonates, such as $Y_2O_3$, $BaCO_3$ and $CuO$, of each element of the oxide superconductor is obtained. Subsequently, the sponge material is heated for burning and is then pulverized by a ball mill or automatic mortar for a predetermined particle size. The burnt sponge material is an aggregate of fine particles with a particle size of 0.1 to 0.6 μm and hence it is easy to produce fine powder mixture of a particle size of 0.1 to 0.6 μm by pulverizing. The fine powder is calcined as described hereinafter.

An alternative method for preparing the starting material is the following so-called coprecipitation method, in which an aqueous solution of the elements is prepared in the same manner as the sol-gel method above-described. A precipitant, such as oxalic acid, potassium oxalate, potassium carbonate and sodium carbonate, is added to the aqueous solution. The amount of the precipitant depends on its kind. Precipitation is carried out by controlling pH of the aqueous solution by adding a basic material, such as an aqueous ammonia, ammonium carbonate and potassium hydroxide. When oxalic acid is used as the precipitant, pH is set to 4.6 and when potassium carbonate is used, it is controlled to 7 to 8. The coprecipitate is heated at 100 to 200°C, preferably 150°C, for drying and then it is calcined 700 to 900°C for 50 hours in a flowing oxygen atmosphere preferably including 90 vol. % or more of oxygen. Then, the calcined material is pulverized by a ball mill or a mortar for a predetermined particle size of the starting material powder..

The filling material may be calcined at 500 to 1000°C for 1 to 100 hours in an oxygen atmosphere, including oxygen gas with an oxygen purity of 90 % or more, preferably nearly 100 %, for removing carbonates and carbon which are contained in it. When the high purity oxygen gas is forced to flow within the calcining furnace without standing, no significant problems are encountered but preferably, the flow rate is 40 $cm^3$/min or more. The calcining may be repeated if necessary. Subsequently, the calcined filling material may be pulverized for a predetermined particle size, for instance, with a ball mill, mixed and then pressed into a bar-shaped compact by conventional methods, for example, cold hydrostatic pressing, such as rubber pressing using a rubber shell and hot hydrostatic pressing, for providing a predetermined green density. The compacting pressure may be 1.5 x $10^8$ to 10 x $10^8$ Pa (1.5 to 10 metric tons/$cm^2$), preferably 1 x $10^8$ to 5 x $10^8$ Pa (1 to 5 metric tons/$cm^2$) although it depends on the kind of the calcined material and on the predetermined green density. The calcining, the pulverizing and pressing operations may be repeated. With such operations, a green density of the compact may be 60 % or more of the theoretical density which has zero porosity. It is preferable to obtain a compact of a green density 70 % or more of the theoretical density.

The calcined, pulverized filling material may be charged into a rubber tube, having one closed end, which is evacuated in a vacuum chamber to a vacuum level, for instance, 3.6 Pa ($10^{-4}$ mmHg), for reducing blowholes in the core heat treated and then is sealed by closing the other open end also in the vacuum chamber. The sealed tube may be wrapped with a soft synthetic resin sheet such as of a polyvinyl chloride resin for enhancing sealing thereof. Then, the rubber tube, wrapped with the synthetic resin, is pressed by means of a hydrostatic rubber press machine to form a compact in the same manner as in the forming of the bar-shape compact above described. The compact thus prepared has few air holes and hence has a relatively high green density and little cracks. This compact may be subject to the subsequent intermediate sintering described below. Then, the compact may be heated at 700 to 1100°C for 1 to 100 hours, preferably at 800 to 1000°C and more preferably at 850 to 950 °C for 1 to 50 hours, in an oxygen atmosphere. With such an intermediate sintering, the sintered compact may have a sintered density of 75 % or more of the theoretical density. This sintered density of 75 % or more provides preferable sintered density that is, 82 % or more, of the sintered core of the composite wire by a heat treatment with ease after subsequent forging or cross-sectional area reduction which will be hereinafter described.

When the sintered density of a sintered compact which has been subjected to the intermediate sintering is set to 70% to 75%, the diameter reduced core thereof may have a green density of 75% to 85% of the theoretical density which provides a sufficient amount of oxygen to the inside of the core 22 having no sheath during subsequent heat treatment for producing a superconductive oxide, so that the sintered core having an excellent superconductivity may be produced with a sintered density of 90% or more of the theoretical density.

The filling material of the superconductive material may be prepared by calcining the starting material powder at 500 to 1000°C for 1 to 50 hours, pressing the calcined powder to form a compact in a similar manner above described, and then heating the compact for 700 to 1100°C for 1 to 100 hours in an oxygen atmosphere or oxygen-containing atmosphere, which will be stated in more detail in paragraphs entitled "The heat treatment", for producing a superconductive oxide. For Y-Ba-Cu oxide superconductor, the compact is heated preferably for 800 to 1000°C for 1 to 50 hours. Thereafter, the heat treated compact is pulverized to obtain a predetermined particle size of the superconducting material powder. These pressing, heating and pulverizing operations may be repeated for producing a superconducting material powder of a homogeneous composition. The superconducting material powder is selected with a conventional method, such as sedimentation, to have a particle size of, typically, 1 μm or smaller and preferably 0.7 μm to 1.5 μm. The superconducting material powder thus selected may be pressed and then subjected to intermediate sintering in the same manner as previously described.

The metallic pipe

The metallic pipe according to the present invention may be made of, for example, copper, a copper alloy, a noble metal such as silver, gold and platinum, an alloy of such a noble metal, aluminum and a stainless steel. The pipe may be made of other metals or plastic materials other than metals.

The thickness of the metallic pipe is preferably 10 to 25 % of the outer diameter thereof. The lower limit of the thickness of the metallic pipe should be such that it does not produce a breaking of the diameter reduced composite wire having a predetermined diameter. The upper limit is determined in view of both the pressure transmittance to the core and the cost of the metallic pipe.

The preform

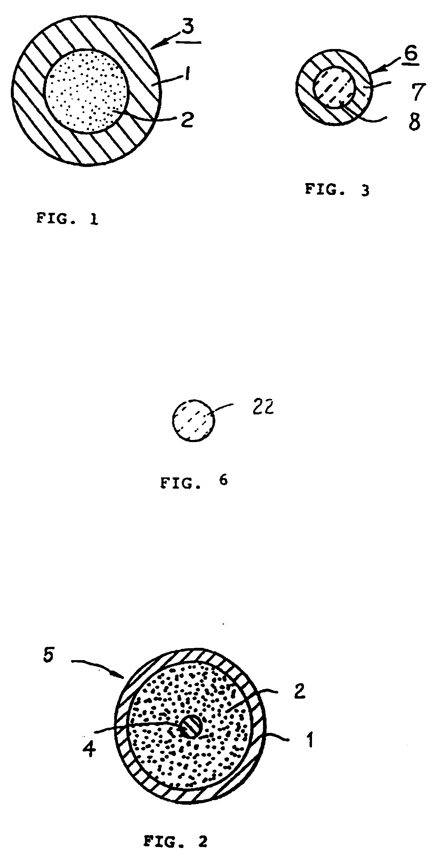

The filling material is charged into the metallic pipe to form a preform. FIG. 1 illustrates a preform 3 which may be, according to the present invention, prepared by inserting a compact 2, made of a superconductor powder, into the metallic pipe 1. The compact 2 may be made by pressing and then sintering a green compact of the superconducting material into a cylindrical shape. The temperature of the sintering may be 400 to 1000 °C. The compact 2 may be made with a rubber shell in a conventional hydrostatic press machine. It is preferable that the gap between the compact 2 and the metallic pipe 1, which fits around the compact 2, is as small as possible so that forging pressure may be sufficiently applied to the core compact in the subsequent diameter reduction.

As illustrated in FIG. 2, the filling material 2 may be, according to the present invention, charged into a metallic pipe 1 into which a core wire 4 is concentrically arranged to form a preform 5. The core wire 4 is made of a non-oxidizing material which does not take oxygen away from the filling material 2 in the metallic pipe 1 during the subsequent heat treatment. The core wire 4 should have a high tensile strength with a melting point higher than 800°C and may include, for example, a metal wire, such as of silver, gold, platinum, titanium, tantalum and a silver alloy, and a ceramic fiber such as a carbon fiber, silica fiber and alumina fiber. The cross-sectional area of the core wire 4 has preferably about 10 % or less of the cross-sectional area of the filling material 2 charged in the metallic pipe 1. With 10 % or less, the core wire 4 provides excellent effects to the superconductor in raising green density of the core of the composite wire and in mechanical strength thereof.

The diameter reduction

In the present invention, the preforms 3 and 5 may be conventionally diameter reduced and formed into a composite wire 6 by well-known methods, for example, drawing with a die, rolling with grooved rolls or swaging such as rotary swaging, to a predetermined diameter. The diameter reduced composite wire 6 has a metallic sheath 7 and a core 8 sheathed with the sheath 7. The diameter reduction operation may be repeated. It is preferable that the forging ratio F is within a range 10 % to 40 % for each diameter reduction operation in which F is defined by the formula

$$F = (S_1 - S_2) \times 100/S_1$$

where $S_1$ and $S_2$ are cross-sectional area of the preform 3, 4 and the diameter-reduced preform or composite wire 6, respectively. Below 10 % of the forging ratio F, the number of the diameter reduction operation is rather increased. Beyond 40 %, it takes rather long period of the processing time.

The preforms 3 and 4 are preferably diameter reduced by rotary swaging using a conventional rotary swaging machine A as in FIG. 1, in which a plurality of dies 10 are arranged about an axis X thereof and are forced to be axially moved (in the direction of the arrow a) during rotating about the axis X (in the direction of the arrow b). The rotary swaging machine A is arranged so that the dies 10 surround the traveling path of the preform 5. The dies 10 are supported to be movable perpendicularly to and to be rotatable about the traveling path. Each of the dies 10 has an inclined face 12 inclined to the axis X so that the inclined faces 12 thereof define a substantially conical working space 14 tapering forwards.

In diameter reduction, the rotary swaging machine A is actuated and then one end of the preform 5 is pushed into the tapering working space 14 of the rotary swaging machine A along the traveling path thereof. The preform 5 is diameter reduced from its one end by the dies 10, which are radially reciprocated and rotated about the axis X, and it is thereby shaped into a composite wire 16 and hence the rotary swaging provides a fairly large forging ratio to the preform 5 as compared to other conventional forging methods. In this rotary swaging machine A, the processing speed or the traveling speed of the preform 3, 5 through it is preferably 0.1 m to 10 m/min.

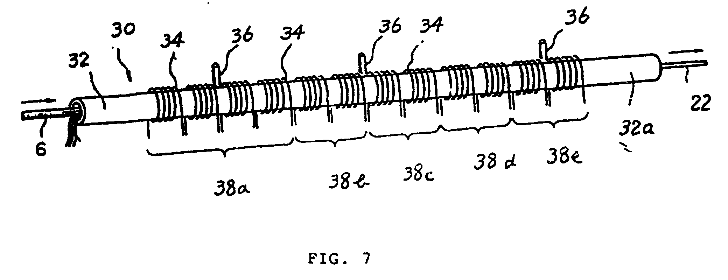

When needed, the composites 6, 16 may be further diameter reduced to a predetermined diameter by means of another rotary swaging machine B in FIG. 5 which has a conical working space 20 smaller than that of the first rotary swaging machine A. In this second diameter reduction, the composite 6, 16 is swaged from the other end to the one end while in the first diameter reduction, it has been diameter reduced from the one end to the other end. Such change in the swaging direction along the axis X provides an increase in green density of the core 8 in the sheath. The swaging operation may be repeated more than twice, in which case the direction of swaging may be changed in each operation or with intervals of a predetermined number of swaging.

The composite wire 6, 16 undergoes the rotary swaging until the green density of the core 8 reaches to about 75 % or more, preferably to about 77 % or more of the theoretical density. With the green density of less than about 75%, superconductivity of the produced oxide superconductor may be degraded since there is an upper limit of increase in density of the core in the the subsequent heat treatment, which will be described hereinafter. The core of composite wire 6, 16 may have a green density of about 75% or more by other conventional methods such as die forging.

The removal of the metallic sheath

The metallic sheath is removed form the composite, diameter reduced, to expose the core 22 thereof to the atmosphere as illustrated in FIG. 6.

The metallic sheath may be, according to the present invention, removed by high frequency induction heating to expose the core 22 and continuously the exposed core 22 may be heat treated for producing the oxide superconductor. In this removing method, the diameter reduced composite 6, 16 may be continuously introduced, as illustrated in FIG. 7, into a heating tube 30 having a glass tube 32, made of a heat-resisting glass, silica glass or a like glass, with an inner diameter of 10 to 20 mm and length of 40 m. The glass tube 32 is arranged in an inclined manner such that the inlet of thereof is lower than the outlet thereof as shown in FIG. 7 so that a molten metal may flow out of the inlet. The heating tube 30 has high frequency induction heating coils 34, wound around the glass tube 32, and is provided with a plurality of, three in this embodiment, oxygen supply tubes 36 mounted to the glass tube 32 to communicate to the inside thereof. Thus, there are provided five heating zones, that is, a first heating zone 38a, second heating zone 38b, third heating zone 38c, fourth heating zone 38d and fifth heating zone 38e from the inlet to the outlet. High frequency current of 5 kHz to 500 kHz is supplied from a power source to respective coils 34 to provide outputs of 1 kW to 100 kW. In this heating tube, high frequency current of 25 kHz is supplied to the first, second, third, fourth and fifth heating zones 38a-38e to yield outputs of 30, 10, 5, 1 and 1 kW, respectively. The length of the first heating zone 38a is 10 m and the length of each of the other heating zones 38b-38e is 5 m. When the composite 6, 16 is introduced into the energized first heating zone 38a of the heating tube 30, eddy current is generated in the metallic sheath 7, so that the latter is melted and removed from the composite 6, 16 to thereby expose the core 8. In this event, no substantial eddy current is generated in the core 8 since it has a volume resistivity of $10^{-3}$ to 1 $\Omega \cdot cm$ and hence it is gradually heated by dielectric loss. Then the core 8 is subsequently moved to the second to fifth heating zones 38b to 38e. Since outputs of the heating zones 38a to 38e are gradually reduced, the core 8 is heated at the highest temperature, in this heating tube 30, of 900°C and then gradually cooled. The speed of the slow cooling depends on the output and the length of each heating zone 38a-38e and traveling speed of the core 8 in the heating tube 30. For preventing cracks from occurring due to rapid cooling, it is preferable to gradually cool the core 22 at a speed of -50 to -500°C/hour while it is cooled from 900°C to 400°C. This induction heating is carried out in an oxygen atmosphere. More specifically, hot oxygen gas which is previously heated is introduced into the glass tube 32 through the oxygen supply tubes 36 to form the oxygen atmosphere, in which the exposed core 22, from which the metallic sheath 7 has been removed, is induction heated and then gradually cooled by the high frequency induction heating coils so that an oxide superconductor with fine crystal structure is produced. In case of production of Y-Ba-Cu-O superconductor, the transformation from a cubic system to a rhombic system thereof may be smoothly carried out with this heating tube 30. Then, the exposed core 22 is pulled out of the heating tube 30 and is preferably cooled at a speed of -50 to -500 °C/hour for preventing cracks from being produced due to rapid cooling. The slow cooling may be carried out in a furnace using a conventional heater without use of the second to fifth heating coils 38b-38e. The core 22 which is issued out of the heating tube 30 may be further heat treated for annealing.

The molten metal of the metallic sheath 7 may be transported to the outside of the heating tube 30 by arranging the latter in an inclined manner so as to discharge it by gravity. Alternatively, a molten metal receiving tape may be introduced into the heat tube 30 so that it passes just below the composite 6 for receiving the molten metal of the metallic pipe 7 and then, the tape is pulled outside to issue out from the heat tube 30 for recovering the molten metal.

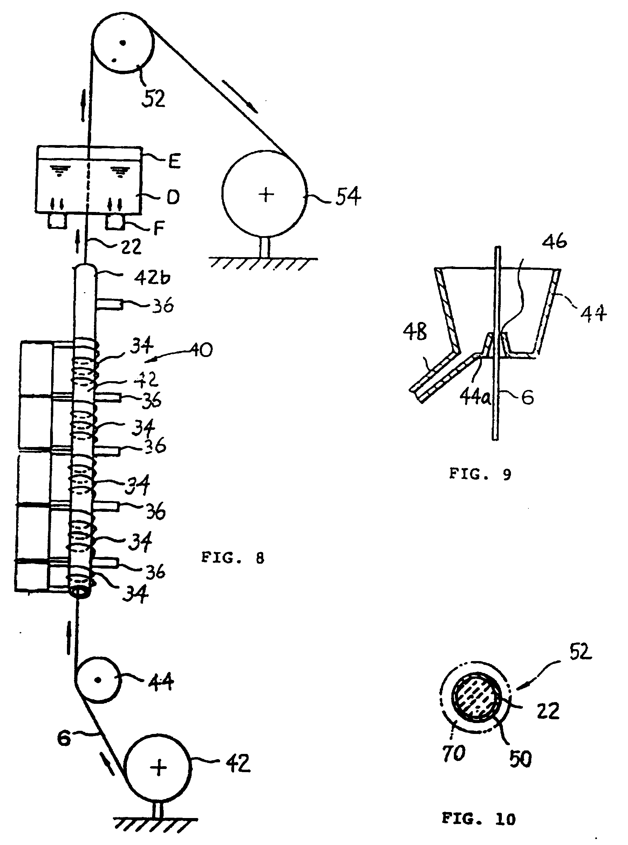

A modified form of the heating tube 30 in FIG. 7 is illustrated in FIG. 8 in which another heating tube 40 is vertically arranged. The composite wire 6 is pulled out from a reel 42 and is then introduced via a roller 44 into the vertical heating tube 40. The wire 6 or the core 22 concentrically passes through the heating tube 40, where the metallic sheath 7 is melted at heating zones and then the exposed core 22 is gradually cooled at the slow cooling portion 42b at an appropriate speed of -50 to -500 °C/hour. The molten metal falls to the bottom of the heating tube 40 where it is preferably collected in a cup 44 (FIG. 9) coaxially located just below the heating tube 40 although the cup 44 is not illustrated in FIG. 8. The composite wire 6 is pulled upwards and coaxially passes the cup 44 through a hole 46 formed through the bottom thereof. The cup 44 has a discharge pipe 48 jointed to its bottom 44a for discharging the collected molten metal to the outside. The exposed core 22 which has issued from the heating tube 40 is subjected to dip forming at a bath E for forming a coating 50 (FIG. 10) and then is wound via a roller 52 around a winding reel 54. In this heating tube 40, the wire 6 and the core 22 vertically passes through the heating tube 40 and hence it is kept vertically without excessive tension for pulling it. This is more preferable for preventing cracks due to tension from occurring than in the heating tube 30 in FIG. 7 where the wire 6 and the core 22 should be kept tight not to touch the inner face of the heating tube 30.

### The heat treatment

After the metallic sheath 7 is removed, the exposed core 22 may, according to the present invention, undergo the heat treatment outside the heating tubes 30, 40 to produce a superconductive oxide without being subjected to the heat treatment within the heating tubes. The heat treatment may be made in an oxygen atmosphere with oxygen content of 90 volume % or more at 800 to 1100°C for 1 to 500 hours. This heat treatment is preferably carried out at 850 to 920°C for 1 to 100 hours. Below 850°C, it takes a considerable time to increase the sintered density and above 920°C, the crystal grain of the oxide superconductor is liable to have a columnar structure and hence clearances between crystal grains may become relatively large, so that the sintered density may decrease. For producing a Y-Ba-Cu oxide superconductor, after the heat treatment the core is preferably gradually cooled at -100°C/hour and may be maintained at 400 to 600°C for 5 to 50 hours for transforming a cubic system to a rhombic system of the crystal structure during the slow cooling. With the oxygen concentration of 90 volume % or more, excellent superconductor may be produced. The purity of the oxygen gas is preferably 90 % or more and flow rate of such high purity oxygen gas may be 0.5 to 5 liters/min. The heat treatment may be carried out in a pressurized atmosphere, in which the pressure of oxygen gas is preferably 1.5 to 5 atmosphere. The core 8 becomes an excellent oxide superconductor since it is exposed to the oxygen atmosphere and is supplied with a sufficient amount of oxygen from the atmosphere. Furthermore, the metallic sheath is removed from the core 8 during the heat treatment, and hence any crack due to stresses which may be caused by the difference in thermal expansion coefficient between them occurs. When the preform is subjected to the rotary swaging as previously described so that the green density of the core 8 reaches to 75% or more of the theoretical density, the sintered density of the heat treated core 22 may become 90 to 95% of the theoretical density, which provides an excellent superconductivity to the finished superconductor. When the green density of the core of the composite is 82% or more, then the sintered density of the heat treated core may be 91 % or more.

Instead of the oxygen atmosphere, other gases, such as an oxygen gas mixture including, VIb group gas, such as S, Se, Te or Po gas other than oxygen gas, VIIb group gas, such as F, Cl or Br, or an inert gas, such as He, Ne, Ar, Kr, Xe or Rn gas, may be used for the heat treatment. With these gas mixture atmospheres, such elements may diffuse into the core and hence the heat treated core has at its surface portion a superconductive oxide having a uniform superconductivity along its axis. Thus, excellent oxide superconductor may be produced.

### The coating treatment

After the heat treatment, the core 22 may be subjected to a coating treatment during application of ultrasonic waves and thereby a superconducting wire 52 having the core 22 coated with the coating layer 50 is obtained as illustrated in FIG. 10. The coating layer 50 may have a thickness 5μm to 100μm, and preferably 10μ to 50μm. The coating treatment may be made by electroplating, hot dipping and similar coating of: a solder, such as of an alloy of zinc and copper and an alloy of tin and lead; a low melting point metal, such as aluminum, tin, zinc, lead, indium, gallium and bismuth, an alloy thereof; and a synthetic resin such as a polyimideamide resin, formal, Teflon resin, nylon and polyvinyl chloride. Metals, such as aluminum, having low electric resistance at liquid nitrogen temperature are preferably used for the coating metal. The metallic coating layer of such metals may be used as a stabilizing layer of the superconductor. Another specific coating technique is that a powder of such low melting point metals or their alloys is adhered to the surface of the heat treated core 22 to form a coating, which is then sintered. With the coating 50, elements, such as oxygen, of the superconductive oxide are prevented from leaving it and are protected from foreign materials such as moisture. Thus, the coating 50 maintains excellent superconductivity for a fairly long period of time. The melting temperature of the solders and low melting metals are below 800 °C, preferably below the temperature at which the crystal structure of the superconductive oxide in the core may be affected.

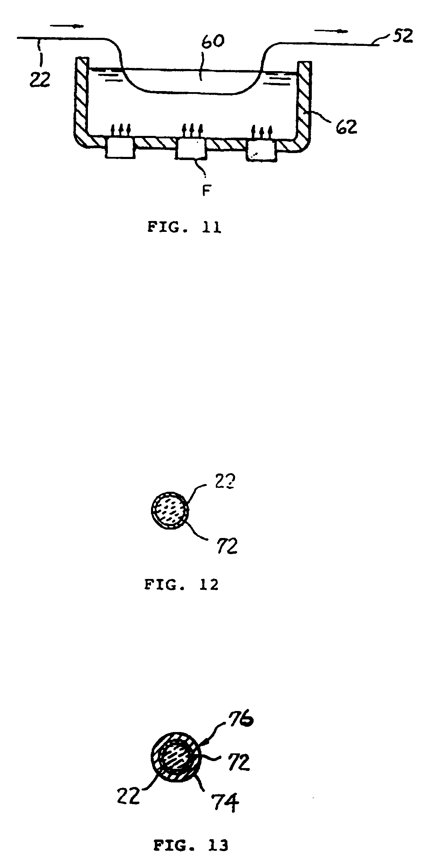

FIG. 11 illustrates a hot dipping process, in which the core 22, heat treated, may be continuously passed through a molten solder 60, such as of an alloy of zinc and copper or an alloy of tin and lead, in a treating bath 62, and after a predetermined period of time, it is taken up from the bath 62 and cooled to solidify the solder 60 adhered to the core 22, so that a superconducting wire 52 having a predetermined thickness of coating layer is produced. An ultrasonic wave generator 64 may be mounted to the bath 62 for applying ultrasonic waves through the molten solder 60 to the core 22 passing through it. By applying ultrasonic waves, air or other substances adhered to the core 22 is removed from it for improving wettability thereof, so that the solder 60 is strongly bonded to the core. Ultrasonic waves having a frequency of 5 kHz to 200 kHz are preferably used.

The coated oxide superconducting wire 52 may further undergo a plating treatment for coating the coating layer with a metallic layer 70, made of tin, copper or a like metal, to reinforce the core 22 as in FIG. 10.

As illustrated in FIG. 12, the heat treated core 22 may be coated with a buffer layer 72 for reducing thermal stresses which are produced in it when it is cooled at liquid nitrogen temperature. In this case, the coating layer and metallic layer are omitted. The buffer layer 72 may be made of a substance which is intermediate in coefficient of thermal expansion between the heat treated core 22 and the a metallic sheath 74 which will be described later. The metals or alloys above mentioned may be used for the buffer layer 72. The buffer layer 72 may be formed by winding a tape, made of such materials, around the heat treated core 22 or placing it to surround the core so that the tape extends along the axis thereof. Hot-dipping, vapor deposition and dip forming may be also adopted for forming the buffer layer 72. The metallic sheath 74, such as of aluminum and copper, may be formed around the buffer layer 72 to form a sheathed superconductor wire 76. The metallic sheath 74 may be formed by covering the buffer layer 72 with a tube, made of a tape or a thin plate, by means of a conventional sheath forming method using dies or forming rolls without forming a gap between the metallic sheath 74 and the buffer layer 72. The superconducting wire 76 thus fabricated may be wound around a core of a superconducting magnet as a coil or may be used for power transmission.

Production of multifilamentary superconductors

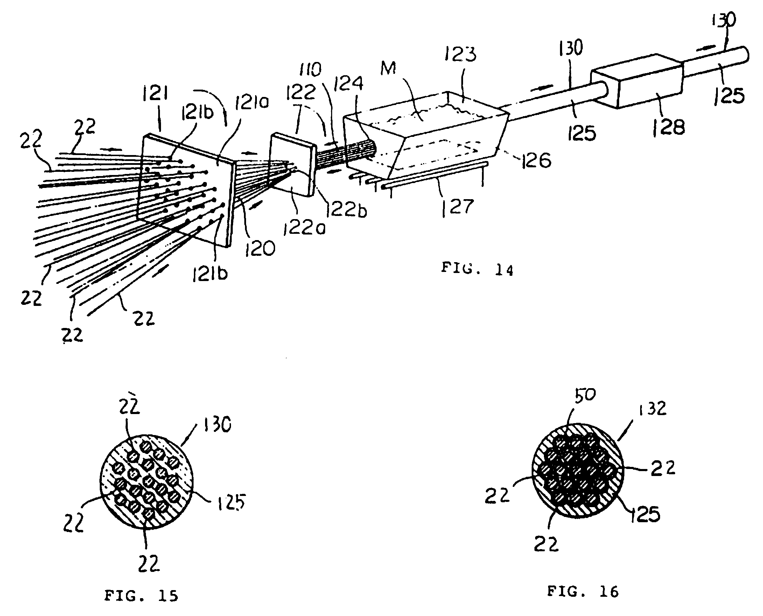

A plurality of, several tens, coated superconductors 52 are arranged through respective holes 121b which are formed through a first separator 121 with regular intervals as shown in FIG. 14. The first separator 121 makes the coated superconductors 52 straight and places them in parallel to each other. Then, the superconductors 52 pass through holes 122b formed through a second separator 122 with predetermined regular intervals for arranging them in a bundle 110 with predetermined regular intervals, which this then passes through a molten metal bath 123, which contains a molten metal M which is the same kind of metal as the coating metal 50 hereinbefore mentioned. The superconductors 52 enter the bath 123 sealingly through bushings of the inlet 124, which keeps the bundle in the predetermined regular intervals, and issue from it through dies of the outlet, the dies sealing the molten metal M. Roller dies are preferably used as the dies of the outlet for reducing load which is applied to the superconductors 130 when they come out of the bath 123. The bath 123 has a ultrasonic wave generator 126 at the inner bottom thereof for vibrating the molten metal M and heaters 127 below the bottom for heating the molten metal M. When the bundle 110 of the superconductors 52 issues from the bath 123, the molten metal M, adhered to it, is solidified to form a bundle coating 125 coating it, so that a multifilamentary superconducting wire 130, as illustrated in FIG. 15, is fabricated. When the superconductors 52 have a large mechanical strength, the bundle 110 thereof may be twisted for enhancing magnetic stability of the multifilamentary superconductor 130. In such a case, the first and second separators 121 and 122 may be synchronously rotated at low speeds for twisting the bundle 110 between the second separator 122 and the outlet of the bath. The molten metal may be metals previously mentioned in connection with the coating metals 50. The multifilamentary superconductor 130 is water cooled with a water cooling device 128. when the bundle coating 125 is made of aluminum, it serves as a stabilizer when superconductive state of the superconductor is broken.

When the coating 50 and the bundle boating 125 are made of different metals, a multifilamentary superconductor 132 as illustrated in FIG. 16 is fabricated. In this case, the coating 50 may be formed of a metal having a melting point higher than that of the bundle coating 125.

Instead of the coated superconductors 52, uncoated superconductors 22 may be used for producing a multifilamentary superconductor in a similar manner.

Other preferred modes of the Invention

It has been discovered that when superconducting materials are calcined or sintered at high temperatures for a long period of time for enlarging crystal grains, clearances between crystal grain may excessively increase, so that oxide superconductors produced may be rather degraded in critical current density. For reducing this drawback, calcining, intermediate sintering and sintering operations may be carried out in the following conditions although other production conditions of which description is omitted are the same as as hereinbefore described. The filling material may be calcined 800 to 950°C for 6 to 50 hours. Under these conditions, the particle size of the calcined material may be 10 μm or smaller. The calcining temperature is preferably 850 to 920°C. Within this temperature range, the calcined material may have a particle size of 5 μm or smaller, which material facilitates the producing of a superconducting material having a particle size of 10 μm or smaller after intermediate sintering. In the intermediate sintering, a compact, which may be prepared in the same conditions as previously described in the subtitle "The filling material", is subjected to the intermediate sintering at 800 to 950°C, preferably 850 to 920°C, for 6 to 50 hours in oxygen atmosphere and then may be gradually cooled to thereby produce an intermediate sinter rod. The preferable temperature range facilitates to produce an intermediate sintering with fine crystal grains equal to 10 μm or smaller. After the sheathing, cross-sectional area reduction and removing of the sheath, the exposed core undergoes the heat treatment at 800 to 950°C, preferably 800 to 920°C, for 6 to 50 hours in oxygen atmosphere for producing an oxide superconductor with fine crystal structure.

A solidified material which is made of a molten starting material may contain excellent oxide superconductors and from the solidified material an excellent superconductor with relatively high critical current density may be produced. According to this modified method, the superconductor is produced in the same conditions as previously stated except the following. The starting material powder, already stated in connection with "The filling material", is calcined at 750 to 950°C for 3 to 50 hours and then pulverized to a predetermined particle size. Subsequently, the calcined powder is subjected to intermediate sintering at 800 to 950°C for 3 to 50 hours and then cooled to produce a superconductive oxide powder. For producing Bi-Sr-Ca-Cu oxide superconductor, the calcined powder undergoes intermediate sintering preferably at 890°C for 20 min. and then at 880 °C for 9 hours, after which it is rapidly cooled. For Y-Ba-Cu oxide superconductor, the slow cooling previously described, which includes transformation to a rhombic system, is preferably made. The sintered powder is placed in a platinum or CaO crucible where it is heated at 1300°C in an oxygen containing atmosphere to produce a molten material, which is solidified by rapid cooling to a temparature of 800 to 950°C. This rapid cooling may be carried out by taking out the crucible, containing the molten material, from the heating appliance and placing it in the atmosphere. Alternatively, the crucible may be forcedly cooled by using a coolant. After maintained at the temperature 800 to 950°C for several to several tens hours, the solidified material is cooled to room temperature. The cooling to the room temperature may be rapidly made for Bi-Sr-Ca-Cu-O system superconductor. The slow cooling as previously described, which includes transformation to a rhombic system, is preferable for Y-Ba-Cu oxide superconductor. A surface portion of the solidified material thus obtained is cut with a thickness 1 mm or smaller, preferably several μm to several hundreds μm by machining and is then pulverized to produce a surface powder which contains high purity and homogeneous superconductive oxide. The remaining solidified material is remelted and reused for obtaining the surface power in the same manner. Such a powder may be directly obtained by injecting the molten material into the atmosphere at 800 to 950°C with a carrier gas. However, the powder should have a particle size of about several hundreds μm or smaller. These powders, obtained from the solidified material, may be pressed to form the bar - shaped compact, already stated, which may be heat treated at 800 to 950°C for 6 to 50 in an oxygen atmosphere to increase the content of the oxide superconductor. After subjected to sheathing, cross-sectional area reduction and removal of the sheath, the exposed core is sintered at 800 to 950°C for 6 to 50 in an oxygen atmosphere.

Example 1

Powders of $Y_2O_3$ (purity: 99.99%), $BaCO_3$ (purity: 99.9%) and $CuO$ (purity: 99.9%) were weighed so that Y : Ba : Cu = 1 : 2 : 3 in mole ratio, and then mixed to obtain a powder mixture, which were calcined at 900°C for 24 hours in the atmosphere and then pulverized to produce a superconducting powder which includes an oxide superconductor $Y_1Ba_2Cu_3O_{7-\delta}$, The superconducting powder was pressed by a rubber press into a rod compact, which was heated at 890°C for 12 hours in ambient flowing oxygen gas of 2 liters/min to produce a sintered compact, which was in turn inserted into a copper pipe, having an inner diameter 8 mm and outer diameter 15 mm to form a preform. Subsequently, the preform was drawn into a composite wire having an outer diameter 1.5 mm and length 500 mm, of which core had a diameter 0.8 mm. The composite wire was wound around a reel and introduced at a speed of 20 mm/min into a heating tube as shown in FIG. 8, where it was induction heated to melt the sheath for exposing the core. The heating tube had five high frequency induction coils of which first one had a length L1 of 0.5 m and the others had a length L2 of 3 m. Each coil was supplied with 30 kHz to 100 kHz of alternating current. Thus, the coils were adjusted so that the first coil with 0.5 m length was provided with an output of 50 kW for enabling to melt the copper layer, which coated the core of the composite, and the other coils were provided with outputs of 20-100 kW for heating the exposed core of the composite at a temperature 890°C ± 5°C. In the slow cooling portion 42B of the heating tube had a length L=35m for gradually cooling the heated core. In the induction heating, the inside of the heating tube was placed in an oxygen atmosphere by introducing hot oxygen gas at a flow rate of 2 liters/min via oxygen supply tubes 36. A receptacle 44 of FIG. 9 was located below the heating tube 40 for recovering copper molten from the composite 6. After the heat treatment, the heated core was introduced through the bottom of the treating bath E and then issued from the top thereof. During moving in the bath E, the core passed through molten Sn-Pb solder during which ultrasonic waves were applied to it with frequency 60 kHz and output 10W. After issuing from the bath, the core was cooled so that a superconductor wire coated with 50 μm solder coating was produced. No breaking of the superconductor wire was noted. The core of the superconductor had a critical temperature of 91.0°C and critical current density of 15000 A/cm$^2$ in liquid nitrogen.

Example 2

Solutions of nitrates of Bi, Pb, Sr, Ca and Cu were mixed so that Bi:Pb:Sr:Ca:Cu=1.4:0.6:2:2:3 at mole ratio, and then ammonium oxalate was added to coprecipitate oxalates of the superconductor materials, which were dried to obtain a powder mixture with a particle size 0.1μm, which was in turn calcined at 820°C for 12 hours in atmospheric air to produce a calcined powder. The calcined powder was charged into a silver pipe, having an outer diameter 10 mm and a thickness 1.5 mm, to form a preform, which was then diameter reduced by a rotary swaging machine to form a 1.5 mm diameter composite wire, having a 0.8 mm diameter core of a green density 85% of the theoretical density, which was then passed through high frequency induction coils to remove the silver sheath for exposing the core. Subsequently, the exposed core was heat treated at 850°C for 50 hours in atmospheric air to thereby produce a superconductor having a composition $Bi_2Pb_uSr_2Ca_2Cu_3O_v$(u and v undetermined) and a sintered density of 95% of the theoretical density, which was then coated with a 1 mm thick ceramics solder protection coating in a solder bath, containing a molten ceramics solder which includes lead, zinc, tin, aluminum, antimony, titanium, silicon, copper and cadmium, during application of 60 kHz ultrasonic waves at 10W output to the surface of superconductor. The coated superconductor had a critical temperature of 105K and critical current density of $1 \times 10^4$ A/cm$^2$ at 77K.

## Claims

1. A method of producing a superconducting wire including a superconductive oxide represented by the formula

$$A_xB_yC_zD_{7-\delta}$$

wherein A is at least one selected from the group consisting of Y, La, Eu, Ho and Er, B is at least one selected from the group consisting of Sr, Ca and Ba, C consists essentially of Cu, or Cu plus at least one element among Ag, Au and Nb, D consists essentially of O, or O plus at least one element among S, Se, Te, Po, F, Cl, Br, I and At, $0.1 \leqq x \leqq 2.0$, $1 \leqq y \leqq 3$, $1 \leqq z \leqq 3$ and $0 \leqq \delta \leqq 5$, or by the formula

$$A_xB_yCa_zCu_iO_j$$

wherein A consists essentially of Bi or Tl, B consists essentially of Sr or Ba $1 \leqq x \leqq 3$, $1 \leqq y \leqq 3$, $0 \leqq z \leqq 3$ and $0 \leqq i \leqq 4$, comprising the steps of:

    (a) charging into a metallic pipe for forming a preform at least one filling material selected from the group consisting of: a starting material powder of the superconductive oxide; a powder of the superconductive oxide;
    (b) reducing the preform in cross-sectional area to form a composite including a core, made of the at least one filling material, and a metallic sheath covering the core;
    (c) removing the metallic sheath of the composite to expose the core; and
    (d) heat treating the exposed core to produce the superconductive oxide;
    wherein, in step (c), the metallic sheath is removed by high frequency induction heating.

2. A method as recited in Claim 1, wherein the superconductive oxide is represented by the formula

$$A_xB_yCa_zCu_iO_j$$

where A is Tl, B is Ba, x = 2, y = 2, z = 1 or 2 and i = 2, 3 or 4.

3. A method as recited in Claim 1, wherein the superconductive oxide is represented by the formula

$$A_xB_yCa_zCu_iO_j$$

where A is Bi, B is Sr, x = 2, y = 2, z = 1 or 2 and i = 2 or 3.

4. A method as recited in Claim 1, wherein the metallic pipe is made of either aluminium or stainless steel.

5. A method as recited in Claim 1, wherein the heat treating step (d) comprises high frequency induction heating the exposed core to produce the oxide superconductor.

6. A method as recited in Claim 5, wherein the metallic sheath removing step (c) and the heat treating step (d) are carried out by passing the composite/core through an energised high frequency induction heating coil.

7. A method as recited in Claim 6, wherein A is Y, B is Ba, x = 1, y = 2, z = 3 and $\delta$ = about 0, and wherein the heat treating step (d) comprises the step of gradually cooling the core, in which the oxide superconductor has been produced, to transform the crystal structure of the superconductor from a cubic system to an orthorhombic system.

8. A method as recited in Claim 7, wherein the induction heating coil is arranged with its axis vertical, and wherein the core passes vertically through the induction coil.

9. A method as recited in Claim 1, wherein the heat treating step (d) is carried out at about 800 to about 1100°C for about 1 to about 500 hours.

10. A method as recited in Claim 9, wherein the heat treating step (d) is carried out at about 850 to 920°C for about 1 to about 100 hours.

11. A method as recited in Claim 1, which, after the heat treating step (d), further comprises the steps of applying ultrasonic waves to the core for improving wettability thereof and forming a protection coating over the core while the ultrasonic waves are applied.

12. A method as recited in Claim 11, wherein the applied ultrasonic waves have a frequency of about 5 to about 200 kHz.

13. A method as recited in Claim 1, which, after the heat treating step (d), further comprises the steps of: preparing a plurality of cores heat treated in the step (d); bundling the prepared cores into a core bundle; passing the core bundle through a molten metal for adhering the molten metal to each of the cores of the core bundle, the molten low melting point metal having a melting point below the temperature at which the heat treatment is carried out; and cooling the core bundle and adhered metal so as to bury the core bundle in the cooled molten metal and thereby form a multicore superconducting wire.

14. A method as recited in Claim 13, wherein the low melting point metal is a metal selected from the group consisting of aluminium, tin, zinc, indium, gallium, lead and bismuth.

**Patentansprüche**

1. Verfahren zur Herstellung eines supraleitenden Drahtes, der ein supraleitendes Oxid der Formel

$$A_xB_yC_zD_{7-\sigma}$$

einschließt, worin A zumindest ein Bestandteil der Gruppe ist, die aus Y, La, Eu, Ho und Er besteht, B zumindest ein Bestandteil der Gruppe ist, die aus Sr, Ca und Ba besteht, C im wesentlichen aus Cu oder Cu plus zumindest einem Element aus Ag, Au und Nb besteht, D im wesentlichen aus O oder O plus zumindest einem Element aus S, Se, Te, Po, F, Cl, Br, I und At besteht, $0,1 \leqq x \leqq 2,0$, $1 \leqq y \leqq 3$, $1 \leqq z \leqq 3$, und $0 \leqq \delta \leqq 5$, oder der Formel

$$A_xB_yCa_zCu_iO_j$$

worin A im wesentlichen aus Bi oder Tl besteht, B im wesentlichen aus Sr oder Ba besteht $1 \leqq x \leqq 3$, $1 \leqq y \leqq 3$, $0 \leqq z \leqq 3$ und $0 \leqq i \leqq 4$, folgende Schritte umfassend:

(a) das Beschicken eines Metallrohres zum Bilden eines Vorformlings mit zumindest einem Füllmaterial, ausgewählt aus der Gruppe bestehend aus: einem Ausgangsmaterialpulver für das supraleitende Oxid; einem Pulver aus dem supraleitenden Oxid;

(b) die Reduktion der Querschnittsfläche des Vorformlings, um einen Verbundkörper zu bilden, der einen aus dem zumindest einen Füllmaterial gebildeten Kern und eine den Kern bedeckende Metallhülle umfaßt;

(c) das Entfernen der Metallhülle vom Verbundkörper, um den Kern freizulegen; und

(d) die Wärmebehandlung des freigelegten Kerns, um das supraleitende Oxid zu erzeugen;

worin in Schritt (c) die Metallhülle durch Hochfrequenzinduktionserwärmung entfernt wird.

2. Verfahren nach Anspruch 1, worin das supraleitende Oxid die Formel

$$A_xB_yCa_zCu_iO_j$$

hat, worin A Tl ist, B Ba ist, x = 2, y = 2, z = 1 oder 2 und i = 2, 3 oder 4.

3. Verfahren nach Anspruch 1, worin das supraleitende Oxid die Formel

$$A_xB_yCa_zCu_iO_j$$

hat, worin A Bi ist, B Sr ist, x = 2, y = 2, z = 1 oder 2 und i = 2 oder 3.

4. Verfahren nach Anspruch 1, worin das Metallrohr entweder aus Aluminium oder aus rostfreiem Stahl besteht.

5. Verfahren nach Anspruch 1, worin der Wärmebehandlungsschritt (d) die Hochfrequenzinduktionserwärmung des freiliegenden Kerns umfaßt, um den Oxidsupraleiter herzustellen.

6. Verfahren nach Anspruch 5, worin der Schritt (c) des Entfernens der Metallhülle und der Wärmebehandlungsschritt (d) durchgeführt werden, indem der Verbundkörper/Kern durch eine mit Energie beaufschlagte Hochfrequenz-Induktionsheizspule hindurchgeschickt wird.

7. Verfahren nach Anspruch 6, worin A Y ist, B Ba ist, x = 1, y = 2, z = 3 und δ etwa 0 ist, und worin der Wärmebehandlungsschritt (d) den Schritt des allmählichen Abkühlens des Kerns umfaßt, in dem der Oxidsupraleiter erzeugt worden ist, um die Kristallstruktur des Supraleiters aus einem kubischen System in ein orthorhombisches System umzuwandeln.

8. Verfahren nach Anspruch 7, worin die Induktionsheizspule mit vertikal ausgerichteter Achse angeordnet ist und worin der Kern vertikal durch die Induktionsspule hindurch geführt wird.

**9.** Verfahren nach Anspruch 1, worin der Wärmebehandlungsschritt (d) bei etwa 800 bis etwa 1.100°C etwa 1 bis etwa 500 h lang durchgeführt wird.

**10.** Verfahren nach Anspruch 9, worin der Wärmebehandlungsschritt (d) bei etwa 850 bis 920°C etwa 1 bis etwa 100 h lang durchgeführt wird.

**11.** Verfahren nach Anspruch 1, das nach dem Wärmebehandlungsschritt (d) weiters die Schritte des Anlegens von Ultraschallwellen an den Kern, um dessen Benetzbarkeit zu verbessern, und des Bildens einer Schutzbeschichtung über dem Kern, während die Ultraschallwellen angelegt werden, umfaßt.

**12.** Verfahren nach Anspruch 11, worin die angelegten Ultraschallwellen eine Frequenz von etwa 5 bis etwa 200 kHz aufweisen.

**13.** Verfahren nach Anspruch 1, das nach dem Wärmebehandlungsschritt (d) weiters folgende Schritte umfaßt: die Herstellung einer Vielzahl von in Schritt (d) wärmebehandelten Kernen; das Bündeln der hergestellten Kerne zu einem Kernbündel; das Hindurchschicken des Kernbündels durch ein geschmolzenes Metall, damit das geschmolzene Metall an jedem der Kerne des Kernbündels haften bleibt, wobei das geschmolzene Metall mit niedrigem Schmelzpunkt einen Schmelzpunkt unter der Temperatur aufweist, bei der die Wärmebehandlung durchgeführt wird; und das Abkühlen des Kernbündels und des daran haftenden Metalls, um das Kernbündel in dem abgekühlten geschmolzenen Metall einzubetten und dadurch einen Mehrkernsupraleiterdraht zu bilden.

**14.** Verfahren nach Anspruch 13, worin das Metall mit niederem Schmelzpunkt ein Metall ist, das aus der Gruppe ausgewählt ist, die aus Aluminium, Zinn, Zink, Indium, Gallium, Blei und Wismut besteht.

## Revendications

**1.** Méthode d'obtention d'un fil supraconducteur comprenant un oxyde supraconducteur représenté par la formule

$$A_xB_yC_zD_{7-\delta}$$

où est A est au moins l'un choisi dans le groupe consistant en Y, La, Eu, Ho et Er, B est au moins l'un choisi dans le groupe consistant en Sr, Ca et Ba, C consiste essentiellement en Cu ou Cu plus au moins un élément parmi Ag, Au et Nb, D consiste essentiellement en O ou O plus au moins un élément parmi S, Se, Te, Po, F, Cl, Br, I et At, $0,1 \leq x \leq 2,0$, $1 \leq y \leq 3$, $1 \leq z \leq 3$ et $0 \leq \delta \leq 5$ ou bien par la formule

$$A_xB_yCa_zCu_iO_j$$

où A consiste essentiellement en Bi ou Tl, B consiste essentiellement en Sr ou Ba, $1 \leq x \leq 3$, $1 \leq y \leq 3,0$, $0 \leq z \leq 3$ et $0 \leq i \leq 4$, comprenant les étapes de :

(a) introduire dans un tube métallique, pour former une préforme, au moins un matériau de remplissage choisi dans le groupe consistant en : une poudre de matière première de l'oxyde supraconducteur; une poudre de l'oxyde supraconducteur;
(b) réduire en aire en section transversale la pré forme pour former un composite comprenant une âme, faite du au moins un matériau de remplissage et une gaine métallique couvrant l'âme;
(c) enlever la gaine métallique du composite pour exposer l'âme; et
(d) traiter thermiquement l'âme exposée pour obtenir l'oxyde supraconducteur;
où, à l'étape (c), la gaine métallique est enlevée par chauffage à induction à haute fréquence

**2.** Méthode selon la revendication 1, où l'oxyde supraconducteur est représenté par la formule

$$A_xB_yCa_zCu_iO_j$$

où A est Tl, B est Ba, $x = 2$, $y = 2$, $z = 1$ ou 2 et $i = 2$, 3 = 4.

**3.** Méthode selon la revendication 1, où l'oxyde supraconducteur est représenté par la formule

$$A_xB_yCa_zCu_iO_j$$

où A est Bi, B est Sr, $x = 2$, $y = 2$, $z = 1$ ou 2 et $i = 2$ ou 3.

**4.** Méthode selon la revendication 1, où le tube métallique est fait en aluminium ou en acier inoxydable.

**5.** Méthode selon la revendication 1, où l'étape de traitement thermique (d) comprend un chauffage à induction à haute fréquence de l'âme exposée pour produire l'oxyde supraconducteur.

**6.** Méthode selon la revendication 5, où l'étape d'enlèvement de la gaine métallique (c) et l'étape de traitement thermique (d) sont effectuées par passage du composite/âme à travers une bobine de chauffage à induction excitée à haute fréquence.

**7.** Méthode selon la revendication 6, où A est Y, B est Ba, $x = 1$, $y = 2$, $z = 3$ et $\delta =$ environ 0, et où l'étape de traitement thermique (d) comprend l'étape de refroidir graduellement l'âme, dans laquelle l'oxyde supraconducteur a été produit, pour transformer la structure cristalline du supraconducteur d'un système cubique à un système orthorhombique.

8. Méthode selon la revendication 7, où la bobine de chauffage à induction est agencée avec son axe vertical et où l'âme passe verticalement à travers la bobine d'induction.

9. Méthode selon la revendication 1, où l'étape de traitement thermique (d) est effectuée aux environs de 800 à environ 1100°C pendant environ 1 heure à environ 500 heures.

10. Méthode selon la revendication 9, où l'étape de traitement thermique (d), est effectuée aux environs de 850 à 920°C pendant environ 1 à environ 100 heures.

11. Méthode selon la revendication 1 qui, après l'étape de traitement thermique (d) comprend de plus les étapes d'application d'ondes ultrasonores à l'âme pour améliorer sa mouillabilité et former un revêtement protecteur sur l'âme alors que les ondes ultrasonores sont appliquées.

12. Méthode selon la revendication 11, où les ondes ultrasonores appliquées ont une fréquence d'environ 50 à environ 200 Hz.

13. Méthode selon la revendication 1 qui, après l'étape de traitement thermique (d), comprend de plus les étapes de : préparer un certain nombre d'âmes traitées thermiquement à l'étape (d); mettre les âmes préparées en faisceau en un faisceau d'âmes; faire passer le faisceau d'âmes à travers un métal fondu pour faire adhérer le métal fondu à chacune des âmes du faisceau d'âmes, le métal fondu à faible point de fusion ayant un point de fusion en dessous de la température à laquelle est effectué le traitement thermique; et refroidir le faisceau d'âmes et le métal qui lui adhère afin de noyer le faisceau d'âmes dans le métal fondu refroidi pour ainsi former un fil supraconducteur multi-âme.

14. Méthode selon la revendication 13, où le métal à faible point de fusion est un métal sélectionné dans le groupe consistant en aluminium, étain, zinc, indium, gallium, plomb et bismuth.

FIG. 1

FIG. 3

FIG. 6

FIG. 2

FIG. 4

FIG. 5

FIG. 7

FIG. 8

FIG. 9

FIG. 10

FIG. 11

FIG. 12

FIG. 13

FIG. 14

FIG. 15

FIG. 16

EP 0 310 453 B2